# EUROPÄISCHE PATENTSCHRIFT

(11) **EP 3 369 293 B1**
(45) Veröffentlichungstag und Bekanntmachung des Hinweises auf die Patenterteilung: **12.06.2019**
(21) Anmeldenummer: 17822617.1
(22) Anmeldetag: 13.12.2017
(51) Int. Cl.: H05B 37/02, G01D 5/245, G05G 1/08, H01H 19/02, H01H 19/60, H01H 36/02, G05G 13/00, G05G 5/12

(54) **LICHTSTELLBEDIENEINHEIT MIT DOPPELWELLENENCODER**
LIGHT CONTROL OPERATING UNIT HAVING A DOUBLE-SHAFT ENCODER
CONSOLE D'ÉCLAIRAGE COMPRENANT UN CODEUR À DEUX ARBRES

(30) Priorität: 18.01.2017 DE 202017100249 U
(43) Veröffentlichungstag der Anmeldung: 05.09.2018
(73) Patentinhaber: MA Lighting Technology GmbH, 97297 Waldbüttelbrunn (DE)
(72) Erfinder: ADENAU, Michael, 97082 Würzburg (DE)
(74) Vertreter: advotec.
(86) Internationale Anmeldenummer: PCT/EP2017/082636
(87) Internationale Veröffentlichungsnummer: WO 2018/134001

(56) Entgegenhaltungen:
- EP-A2- 1 544 880
- DE-A1-102014 116 827
- US-A- 5 187 630
- US-A- 5 404 152
- US-A1- 2004 210 916

## Beschreibung

Die Erfindung betrifft eine Lichtstellbedieneinheit nach dem Oberbegriff des Anspruchs 1.

Gattungsgemäße Lichtstellbedieneinheiten werden mit einer Rechnereinheit verbunden und dienen zur Steuerung von Beleuchtungsanlagen, wie sie beispielsweise in Theatern oder Konzertbühnen zum Einsatz kommen. Diese Beleuchtungsanlagen umfassen regelmäßig eine Vielzahl von Beleuchtungseinrichtungen, beispielsweise Bühnenscheinwerfer, wobei die Beleuchtungseinrichtungen vielfach auch noch für sich genommen zwischen einer Vielzahl von Beleuchtungszuständen, beispielsweise unterschiedlichen Farben, umgeschaltet werden können. Diese unterschiedlichen Beleuchtungszustände werden durch programmierte Parameter im Beleuchtungsprogramm der Rechnereinheit gespeichert und gesteuert. Übliche Beleuchtungsanlagen können dabei bis zu mehreren tausend Beleuchtungseinrichtungen umfassen. Um derart komplexe Beleuchtungsanlagen steuern zu können, sind die gattungsgemäßen Lichtstellbedieneinheiten mit einem Digitalprozessor ausgestattet, der eine digitale Daten- und Signalverarbeitung erlaubt. Zur Speicherung der Daten ist in der Rechnereinheit weiter ein Digitalspeicher vorgesehen, der es insbesondere ermöglicht, Beleuchtungsprogramme zu archivieren.

Zur Programmierung des Beleuchtungsprogramms bzw. zur Steuerung des Beleuchtungsprogramms während seines Ablaufs müssen vom Bediener Bedienbefehle als Eingabewerte eingegeben werden. Dabei kann es sich beispielsweise um die Auswahl einer bestimmten Beleuchtungseinrichtung bzw. um die Einstellung eines bestimmten Parameters handeln. Für die Eingabe dieser Bedienbefehle sind an bekannten Lichtstellbedieneinheiten mechanische Bedienelemente, beispielsweise Taster, Drehregler oder Schieberegler, vorhanden. Die den einzelnen Bedienelementen zugeordneten Bedienbefehle können dabei durch geeignete Menüumschaltung verändert werden, um entsprechend komplexe Beleuchtungsprogramme programmieren und steuern zu können.

Bei Doppelwellenencodern handelt es sich um Eingabevorrichtungen, an denen ein Benutzer durch Verdrehen eines Betätigungselements ein zugeordnetes elektrisches Signal eingeben kann. Doppelwellenencoder sind dabei dadurch charakterisiert, dass diese nicht nur ein Betätigungselement, beispielsweise einen Drehknopf oder eine Drehscheibe, aufweisen, sondern zwei. Beide Betätigungselemente sind mit einer drehbar gelagerten Welle verbunden. Beiden Wellen ist jeweils ein Drehsignalgeber zugeordnet, der das Verdrehen der Welle unmittelbar oder mittelbar detektieren kann. Die beiden Drehsignalgeber erzeugen dann jeweils nach Detektion einer Stellbewegung an der Welle ein zugeordnetes elektrisches Signal.

Bei bekannten Doppelwellenencodern sind die Bedienelemente drehknopfartig ausgebildet, so dass zur Eingabe eines Parameters am Doppelwellenencoder der entsprechende Drehknopf zwischen Daumen und Zeigefinger verstellt werden muss. Dies bedeutet also mit anderen Worten, dass bei bekannten Doppelwellenencodern die Eingabe eines neuen Wertes das Verdrehen des zugeordneten Drehknopfs am Doppelwellenencoder zwischen Daumen und Zeigefinger erfordert.

Nachteilig an diesen Doppelwellenencodern mit Drehknopf ist es, dass der Bedienkomfort für den Bediener relativ gering ist. Außerdem ist es nicht möglich an beiden Betätigungselementen des Doppelwellenencoders gleichzeitig neue Werte durch Verdrehen der Betätigungselemente einzugeben, da die entsprechende Bedienhand nur einen Daumen umfasst.

Aus der DE 10 2014 116827 A1 ist ein Lichtstellpult mit einem Doppelwellenencoder bekannt. Zur Verstellung des Doppelwellenencoders ist eine Drehscheibe und ein darüber liegend angeordneter Drehring vorgesehen. Aufgrund des unterschiedlichen Höhenniveaus von Drehscheibe und Drehring ist der Bedienkomfort des Benutzers bei Nutzung des Doppelwellenencoders eingeschränkt.

Ausgehend von diesem Stand der Technik ist es deshalb Aufgabe der vorliegenden Erfindung, eine neue Lichtstellbedieneinheit mit Doppelwellenencoder vorzuschlagen, dessen Betätigungselemente, an denen der Doppelwellenencoder verstellt wird, einen höheren Bedienkomfort ermöglichen.

Vorteilhafte Ausführungsformen der Erfindung sind Gegenstand der Unteransprüche.

Die erfindungsgemäße Lichtstellbedieneinheit ist im Bedienfeld mit zumindest einem Doppelwellenencoder zur Eingabe von Eingabewerten ausgestattet. Die Erfindung beruht zunächst auf dem Grundgedanken, dass die Betätigungselemente zur handbetätigten Verstellung der beiden Wellen des Doppelwellenencoders in der Art einer Drehscheibe oder eines Drehrings ausgebildet sind. Durch den Ersatz der üblichen Drehknöpfe an Doppelwellenencodern sowie durch den erfindungsgemäßen Einsatz von Drehscheiben oder Drehringen wird der Bedienkomfort bei der Eingabe von Eingabeparametern erheblich erhöht. Denn aufgrund der größeren Hebeverhältnisse erlaubt eine Drehscheibe bzw. ein Drehring das Verdrehen der Welle des Doppelwellenencoders durch Betätigung mit allein einem Finger. Das Umgreifen des Drehknopfs, wie er bei den bekannten Doppelwellenencodern notwendig ist, entfällt auf diese Weise. Im Ergebnis hat der Bediener somit die Möglichkeit durch Berührung der beiden Drehscheiben bzw. der beiden Drehringe des erfindungsgemäßen Doppelwellenencoders mit zwei getrennten Fingern gleichzeitig zwei Eingabeparameter durch entsprechendes Verstellen der beiden Drehscheiben bzw. der beiden Drehringe zu realisieren. Somit kann auch noch die Eingabegeschwindigkeit entsprechend beschleunigt werden, da zwei Eingabewerte gleichzeitig mit einer Hand an dem Doppelwellenencoder der erfindungsgemäßen Lichtstellbedieneinheit eingegeben werden können.

Um den Bedienkomfort bei der Eingabe von Eingabeparametern am Doppelwellenencoder der Lichtstellbedieneinheit zu erhöhen, ist es erfindungsgemäß vorgesehen, dass die Oberseite der Drehscheibe oder des Drehrings in der Art einer Fingerkuppen-Kontaktfläche ausgebildet ist. Dadurch wird ermöglicht, dass die Drehscheibe oder der Drehring durch Eingriff einer Fingerkuppe an der Fingerkuppen-Kontaktfläche rotatorisch angetrieben werden kann. Um einen verbesserten Griffkontakt zwischen der Fingerkuppen-Kontaktfläche und der zum Eingriff vorgesehenen Fingerkuppe zu ermöglichen, ist es weiterhin erfindungsgemäß vorgesehen, dass die Finger-kuppen-Kontaktfläche konkav gewölbt ist. Durch die konkave Wölbung kann sich die Fingerkuppen-Kontaktfläche zumindest abschnittsweise an die konvex geformte Außenseite der Fingerkuppe anformen, so dass aufgrund der vergrößerten Kontaktfläche ein sicherer Halt der Fingerkuppe auf der Fingerkuppen-Kontaktfläche gegeben ist.

Um den Benutzer möglichst viel Bewegungsfreiheit beim Eingriff auf der Fingerkuppen-Kontaktfläche zu geben, ist es erfindungsgemäß vorgesehen, dass die Fingerkuppen-Kontaktfläche eine kreisringförmige Gestalt aufweist. Alternativ dazu kann die Fingerkuppen-Kontaktfläche auch eine kreisförmige Gestalt aufweisen. Innerhalb der kreisringförmigen oder kreisförmigen Fingerkuppen-Kontaktfläche kann der Benutzer dann seine Fingerkuppen relativ frei positionieren und erhält jeweils einen zuverlässigen Kontakt mit der Fingerkuppen-Kontaktfläche.

Um mit zwei Fingern gleichzeitig die beiden Drehscheiben bzw. die beiden Drehringe oder die eine Drehscheibe mit dem zugeordneten Drehring des Encoders gleichzeitig verstellen zu können, ist es erfindungsgemäß vorgesehen, dass die beiden Drehscheiben oder Drehringe, mit denen die beiden Wellen des Doppelwellenencoders angetrieben werden, auf der gleichen Höhe relativ zur Außenseite des Gehäuses angeordnet sind. Durch entsprechende Annäherung der Finger von oben auf die beiden Fingerkuppen-Kontaktflächen, die somit auf gleicher Höhe verlaufen, kann dann bei sehr guter Ergonomie eine gleichzeitige Verstellung der beiden Betätigungselemente des Doppelwellenencoders realisiert werden.

Im Hinblick auf eine hohe Verschleißfestigkeit ist es vorteilhaft, wenn an der ersten Welle ein erstes Rastwerk zur Verrastung unterschiedlicher Drehlagen der ersten Welle vorgesehen ist, wobei der erste Drehsignalgeber zur Erzeugung eines ein Umschalten zwischen zwei Rastlagen anzeigenden Datensignals vorgesehen ist. Weiter ist an der zweiten Welle ein zweites Rastwerk zur Verrastung unterschiedlicher Drehlagen der zweiten Welle vorgesehen, wobei der zweite Drehsignalgeber zur Erzeugung eines ein Umschalten zwischen zwei Rastlagen anzeigenden Datensignals vorgesehen ist.

In der einfachsten Bauform ist die Lichtstellbedieneinheit in ein Gehäuse eingebaut und umfasst keine eigene Anzeigeeinrichtung. Zum Betrieb der Lichtstellbedieneinheit bei der Steuerung einer Beleuchtungsanlage wird die Lichtstellbedieneinheit über eine Datenverbindung mit einer Rechnereinheit verbunden. Bei der Datenschnittstelle der Datenverbindung kann es sich beispielweise um eine drahtgebundene USB-Schnittstelle handeln. Bei der drahtgebundenen USB-Schnittstelle werden die Daten über ein Verbindungskabel zwischen den Gehäusen von Lichtstellbedieneinheit und Rechnereinheit übertragen. Alternativ sind auch drahtlose Datenschnittstellen denkbar, wie zum Beispiel eine WLAN-Schnittstelle.

Am Gehäuse der Lichtstellbedieneinheit ist der Doppelwellenencoder vorgesehen. Auch die übrigen Bedienelemente, die der Programmierung des Beleuchtungsprogramms dienen, wie Drehregler, Taster etc., sind in das Gehäuse der Lichtstellbedieneinheit eingebaut worden. Das Gehäuse der Rechnereinheit umfasst den Digitalprozessor und zumindest einen Digitalspeicher zur Erzeugung, Verwaltung und Speicherung von Stellbefehlen.

Die Rechnereinheit kann außerdem die Anzeigeeinrichtung umfassen, an der Grafikelemente für den Benutzer grafisch dargestellt werden.

Ist die Rechnereinheit in der Art eines Laptops oder Personal Computers ausgebildet, so kann ein solches Standardgerät durch Koppelung mit der Lichtstellbedieneinheit, die den Doppelwellenencoder und die übrigen Bedienelemente enthält, die der Programmierung des Beleuchtungsprogramms dienen, zur Realisation der Funktion eines kompletten Lichtstellpults genutzt werden.

Gemäß einer ersten Verfahrensvariante ist es vorgesehen, dass zunächst eine Verstellung des Betätigungselements an der ersten Welle stattfindet. Danach erfolgt eine Auswertung des Datensignals am ersten Drehsignalgeber. Der so festgestellte Ausgangswert des Drehsignalgebers wird dann zur Verstellung eines an der Anzeigeeinrichtung angezeigten Cursors in horizontaler Richtung verwendet.

Anschießend erfolgen die Verstellung des Betätigungselements an der zweiten Welle und die Auswertung des Datensignals am zweiten Drehsignalgeber. Der so festgestellte Ausgangswert des zweiten Drehsignalgebers wird dann zur Verstellung des Cursors an der Anzeigeneinrichtung in vertikaler Richtung genutzt. Durch gleichzeitige Verstellung der beiden Betätigungselemente an dem Doppelwellenencoder kann also der Cursor vom Benutzer gleichzeitig in vertikaler und in horizontaler Richtung verstellt werden.

Für die horizontale bzw. vertikale Verstellung des Cursors gibt es eine Vielzahl von unterschiedlichen Anwendungsfällen an erfindungsgemäßen Lichtstellbedieneinheiten. Gemäß einer bevorzugten Verfahrensvariante ist es vorgesehen, dass die horizontale und vertikale Verstellung des Cursors benutzt werden kann, um die Spalten und Zeilen einer Tabelle oder die Spalten und Zeilen eines Auswahlmenüs zu durchfahren. Dies bedeutet also mit anderen Worten, dass durch Verstellung der beiden Betätigungselemente des Doppelwellenencoders an der erfindungsgemäßen Lichtstellbedieneinheit der Cursor nacheinander oder auch gleichzeitig durch die Spalten und Zeilen einer Tabelle oder durch die Spalten und Zeilen eines Auswahlmenüs bewegt werden kann.

Gemäß einer alternativen Verfahrensvariante ist es vorgesehen, dass das Auswertesignal des ersten Drehsignalgebers für die Grobeinstellung eines Betriebsparameters und das Ausgangssignal des zweiten Drehsignalgebers für die Feineinstellung des zuvor grob eingestellten Betriebsparameters genutzt wird. Auf diese Weise kann der Benutzer sehr einfach und sehr schnell eine zunächst grobe Einstellung des Betriebsparameters und eine darauf folgende Feineinstellung des Betriebsparameters durch Betätigung der beiden Betätigungselemente des Doppelwellenencoders realisieren.

Wird durch das beschriebene Verfahren eine Grob- und Feineinstellung realisiert, ist es weiterhin besonders vorteilhaft, wenn durch Betätigung eines Schaltsensors eine Ultragrobeinstellung oder eine Ultrafeineinstellung des jeweiligen Betriebsparameters in Abhängigkeit der Auswertung des ersten oder zweiten Drehsignalgebers erfolgen kann. Durch Drücken beispielsweise eines Drucktasters neben dem Doppelwellenencoder kann somit eine weitere Umschaltung erfolgen, so dass der Betriebsparameter noch schneller und noch feinfühliger vom Benutzer eingegeben werden kann. Gemäß einer weiteren Verfahrensvariante ist es vorgesehen, dass durch die Auswertung des Ausgangssignals des ersten Drehsignalgebers die Einstellung eines ersten Farblichtparameters einer Beleuchtungseinrichtung erfolgt. Danach oder gleichzeitig kann durch Auswertung des Datensignals des zweiten Drehsignalgebers die Einstellung eines zweiten Farblichtparameters der gleichen Beleuchtungseinrichtung erfolgen, so dass der Benutzer auf diese Weise beispielsweise die Lichtfarbe und/oder die Lichtintensität und/oder die Lichttemperatur einer Beleuchtungseinrichtung weitgehend gleichzeitig durch Betätigung der beiden Betätigungselemente eingeben kann.

Gemäß einer weiteren Verfahrensvariante ist es vorgesehen, dass durch Auswertung der Datensignale des ersten Drehsignalgebers die Einstellung eines ersten Bewegungsparameters einer Beleuchtungseinrichtung und dann durch Auswertung des Datensignals des zweiten Drehsignalgebers die Einstellung eines zweiten Bewegungsparameters der gleichen Beleuchtungseinrichtung erfolgen kann.

Auf diese Weise kann beispielsweise sehr einfach die Pan-Einstellung und die Tilt-Einstellung einer in zwei Bewegungsachsen verstellbar gelagerten Beleuchtungseinrichtung durch Nutzung des Doppelwellenencoders an der erfindungsgemäßen Lichtstellbedieneinheit eingegeben werden.

Gemäß einer weiteren Verfahrensvariante kann die Auswertung des Datensignals des ersten Drehsignalgebers zur Einstellung eines ersten Zeitmessparameters, beispielsweise zur Einstellung der Minuten, genutzt werden. Durch Auswertung des Datensignals am zweiten Drehsignalgeber kann dann die Einstellung eines zweiten Zeitmessparameters, beispielsweise der Sekunden, erfolgen.

Eine Ausführungsform der Erfindung ist in den Zeichnungen schematisch dargestellt und wird nachfolgend beispielhaft erläutert.

Es zeigen:
- **Fig. 1**: eine Lichtstellbedieneinheit mit mehreren Doppelwellenencodern in perspektivischer Ansicht von oben;
- **Fig. 2**: die Lichtstellbedieneinheit gemäß Fig. 1 nach Anschluss an eine Rechnereinheit in perspektivischer Ansicht von oben;
- **Fig. 3**: einen Ausschnitt der Elektronikplatine der Lichtstellbedieneinheit gemäß Fig. 1, auf der die Doppelwellenencoder montiert sind, in perspektivischer Ansicht von oben;
- **Fig. 4**: einen Doppelwellenencoder der Lichtstellbedieneinheit gemäß Fig. 1 in perspektivischer seitlicher Ansicht;
- **Fig. 5**: die beiden Betätigungselemente des Doppelwellenencoders gemäß Fig. 4 in perspektivischer Ansicht von oben;
- **Fig. 6**: die Betätigungselemente gemäß Fig. 5 in seitlicher Ansicht;
- **Fig. 7**: die Betätigungselemente gemäß Fig. 5 in Ansicht von oben;
- **Fig. 8**: die Betätigungselemente gemäß Fig. 7 im Querschnitt entlang der Schnittlinie A-A;
- **Fig. 9**: die Betätigungselemente gemäß Fig. 5 im demontierten Zustand in seitlicher Ansicht;
- **Fig. 10**: die Betätigungselemente gemäß Fig. 5 im demontierten Zustand in Ansicht von oben.

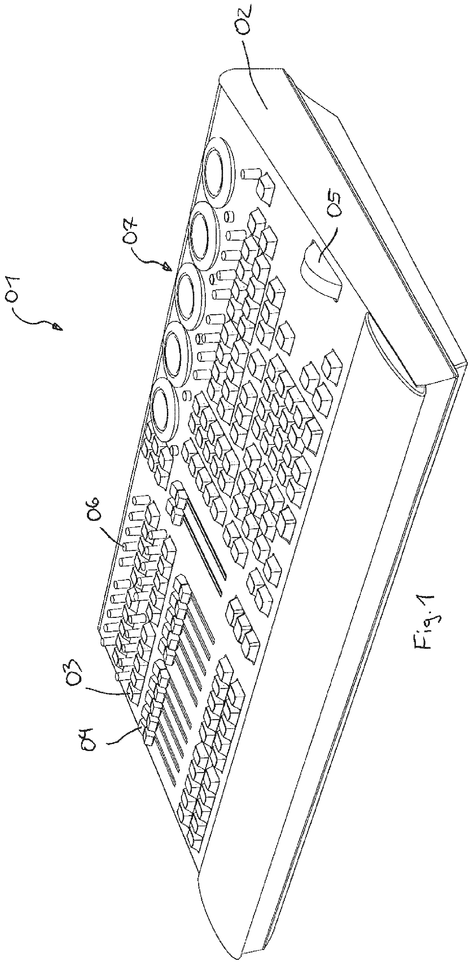

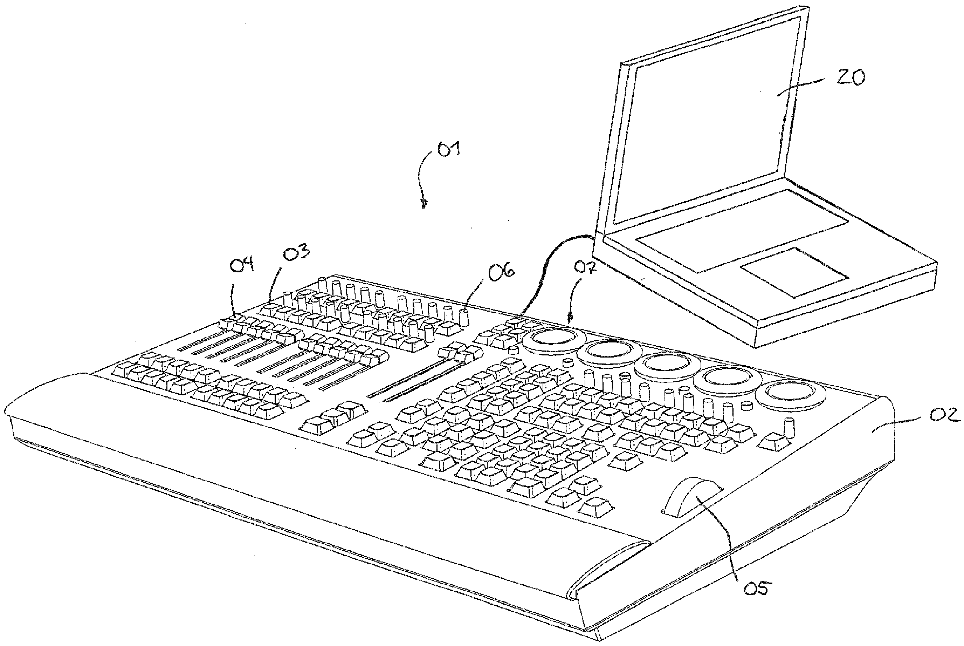

**Fig. 1** zeigt in perspektivischer Ansicht eine erfindungsgemäße Lichtstellbedieneinheit 01 zur Programmierung und Steuerung einer Bühnenbeleuchtungsanlage. Die Lichtstellbedieneinheit 01 ist in ein Gehäuse 02 eingebaut und wird zur Steuerung einer Bühnenbeleuchtungsanlage mit einer Rechnereinheit 20 **(siehe** **Fig. 2****)**, nämlich einem Laptop, verbunden. Zur Eingabe von Stellbefehlen sind an der Lichtstellbedieneinheit 01 eine Vielzahl von Tastern 03, Schieberegler 04, Stellräder 05 und Drehknöpfen 06 vorgesehen. Außerdem sind zur Eingabe von Bedienbefehlen fünf Doppelwellenencoder 07 in das Bedienfeld 08 der Lichtstellbedieneinheit 01 eingebaut.

**Fig. 2** zeigt die Lichtstellbedieneinheit mit der daran angeschlossenen Rechnereinheit 20 gemäß Fig. 1 in Ansicht von oben.

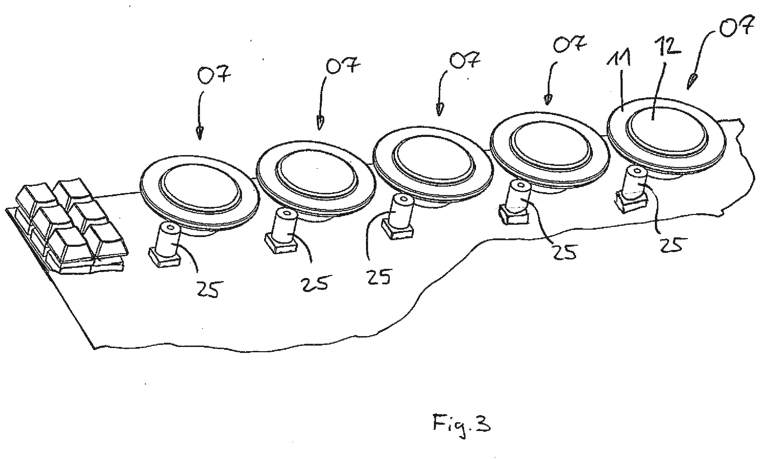

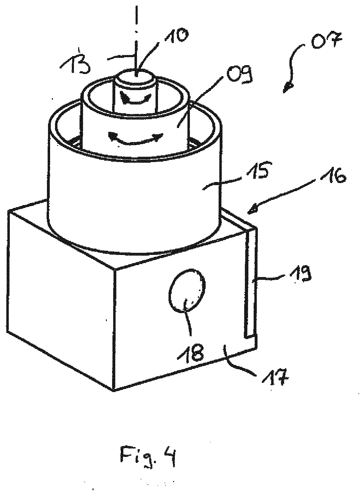

**Fig. 3** zeigt eine Elektronikplatine der Lichtstellbedieneinheit 01, auf der die Doppelwellenencoder 07 montiert sind, in einem perspektivischen Ausschnitt in Ansicht von oben. Die in das Bedienfeld 08 der Lichtstellbedieneinheit 01 eingebauten Doppelwellenencoder 07 weisen jeweils zwei drehbar gelagerte Wellen, nämlich eine Hohlwelle 09 und eine darin koaxial drehbar gelagerte Zentralwelle 10 auf (siehe Fig. 4). Am oberen Ende der Hohlwelle 09 und der Zentralwelle 10 sind zwei unabhängig voneinander verstellbare Betätigungselemente, nämlich ein Drehring 11 und eine Drehscheibe 12 befestigt. Mit dem Drehring 11 kann die Hohlwelle 09 verstellt werden. Mit der Drehscheibe 12 kann die Zentralwelle 10 verdreht werden.

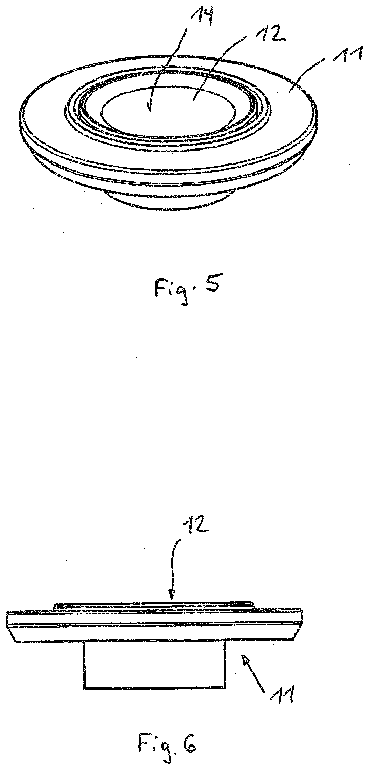

Durch Handbetätigung der Drehscheibe 12 bzw. des Drehrings 11 können also die Hohlwelle 09 und die Zentralwelle 10 rotatorisch um ihre Längsachse unabhängig voneinander verdreht werden, um dadurch Stellbefehle an der Lichtstellbedieneinheit einzugeben. Die Hohlwelle 09 ist dabei zusätzlich axial in Richtung der Längsachse 12 verstellbar gelagert, so dass der Benutzer durch Druck auf die Oberseite 14 (siehe Fig. 5) der Drehscheibe 12 einen durch Verdrehen der Hohlwelle 09 eingestellten Wert auswählen und bestätigen kann. Neben jedem Doppelwellenencoder 07 ist ein Drucktaster 25 angeordnet, mit welchen die Funktionalitäten der Doppelwellenencoder 07 im Sinne einer Shift-Schalter umgeschaltet werden können.

**Fig. 4** zeigt den unteren Teil des Doppelwellenencoders 07 mit den drehbar gelagerten Wellen 09 und 10 in perspektivischer seitlicher Ansicht.

Die Hohlwelle 09 ist im zylindrischen Oberteil 15 des Gehäuses 16 drehbar gelagert. Die Zentralwelle 10 ist in der Hohlwelle 09 drehbar gelagert. An das Oberteil 15 des Gehäuses 16 schließt sich ein rechteckiges Unterteil 17 an, das der Befestigung des Doppelwellenencoders 07 im Gehäuse der Lichtstellbedieneinheit 01 dient.

**Fig. 5** zeigt die beiden Betätigungselemente des Doppelwellenencoders 07, nämlich den Drehring 11 und die Drehscheibe 12, in perspektivischer seitlicher Ansicht.

**Fig. 6** zeigt den Drehring 11 und die Drehscheibe 12 in seitlicher Ansicht.

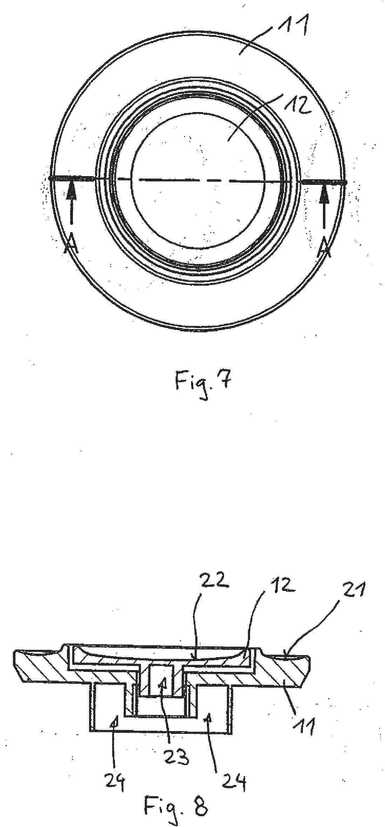

**Fig. 7** zeigt den Drehring 11 und die Drehscheibe 12 in Ansicht von oben.

**Fig. 8** zeigt den Drehring 11 und die Drehscheibe 12 im Querschnitt. An der Oberseite des Drehrings 11 und der Drehscheibe 12 sind jeweils konkav gewölbte Fingerkuppen-Kontaktflächen 21 bzw. 22 vorgesehen, an denen jeweils ein Finger des Benutzers mit der Fingerkuppe zum Eingriff kommen kann, um mit den beiden Fingern beide Betätigungselemente des Doppelwellenencoders 07 gleichzeitig verstellen zu können. Die Fingerkuppen-Kontaktfläche 21 ist dabei kreisringförmig ausgestaltet, wohingegen die Fingerkuppen-Kontaktfläche 22 kreisförmige Gestalt aufweist. Die Zentralwelle 10 wird von unten in die Ausnehmung 23 der Drehscheibe 12 eingesteckt. Die Hohlwelle 09 wird von unten in die Ausnehmung 24 des Drehrings 11 eingesteckt. Beide Fingerkuppen-Kontaktflächen 21 und 22 der beiden Betätigungselemente des Doppelwellenencoders 07 befinden sich auf der gleichen Höhe und erlauben eine ergonomische Betätigung des Doppelwellenencoders 07 mit zwei Fingern.

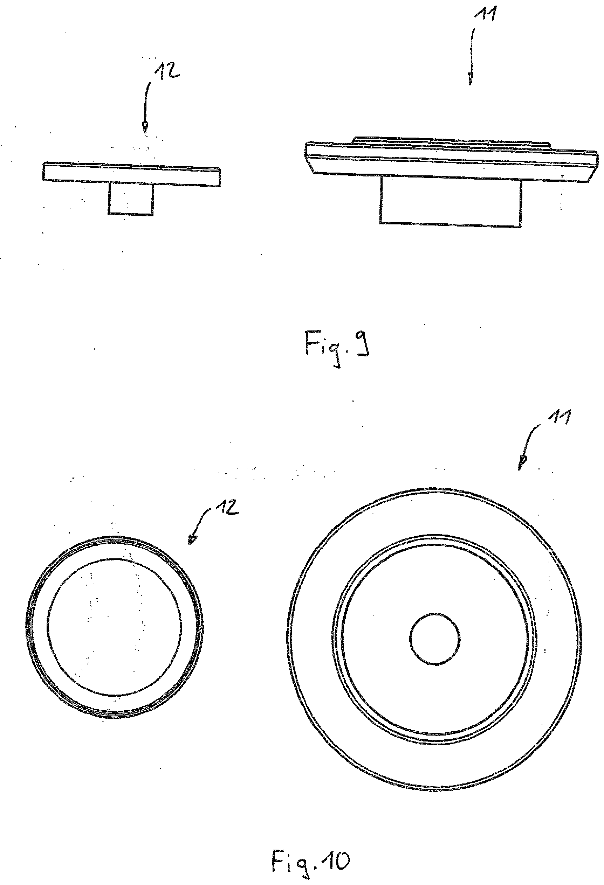

**Fig. 9** und **Fig. 10** zeigen die Drehscheibe 12 und den Drehring 11 im demontierten Zustand in seitlicher Ansicht bzw. in Ansicht von oben.

## Patentansprüche

1. Lichtstellbedieneinheit (01) für ein Beleuchtungssystem, wobei in der Lichtstellbedieneinheit (01) digitale Stellbefehle erzeugt werden, die über eine Datenverbindung an eine Rechnereinheit (20) übertragen werden können, und wobei die Lichtstellbedieneinheit (01) mehrere Bedienelemente, insbesondere Tasten (03), Schieberegler (04) und/oder Drehregler (05), umfasst, die an der Oberseite eines Gehäuses (02) angeordnet sind und mit denen Bedienbefehle eingegeben werden können,
**dadurch gekennzeichnet,**
**dass** in einem Bedienfeld (08) der Lichtstellbedieneinheit (01) zumindest ein Doppelwellenencoder (07) vorgesehen ist, an dem Eingabewerte vom Benutzer eingegeben werden können, wobei der Doppelwellenencoder (07) eine erste drehbar in einem Gehäuse (16) gelagerte Welle (09) aufweist, und wobei an der ersten Welle ein erster Drehsignalgeber zur Erzeugung eines Datensignals vorgesehen ist, und wobei am Doppelwellenencoder (07) eine zweite, koaxial drehbar in dem Gehäuse (16) des Doppelwellenencoders (07) gelagerte Welle (10) vorgesehen ist, und wobei an der zweiten Welle (10) ein zweiter Drehsignalgeber zur Erzeugung eines Datensignals vorgesehen ist, und wobei beide Wellen (09, 10) Betätigungselemente (11, 12) aufweisen, an denen Stellbewegungen von Hand auf die Wellen (09, 10) übertragen werden können, und wobei die Betätigungselemente zur handbetätigten Verstellung der Wellen (09, 10) in der Art einer Drehscheibe (12) und/oder eines Drehrings (11) ausgebildet sind, die im Bedienfeld (08) der Lichtstellbedieneinheit (01) angeordnet sind und koaxial gegeneinander verdreht werden können, wobei jeweils die Oberseite der Drehscheibe (12) bzw. des Drehrings (11) in der Art einer Fingerkuppen-Kontaktfläche (21, 22) ausgebildet ist, wobei die Drehscheibe (12) bzw. der Drehring (11) durch Eingriff einer Fingerkuppe an der Fingerkuppen-Kontaktfläche (21, 22) rotatorisch antreibbar ist, und wobei die Fingerkuppen-Kontaktfläche (21, 22) konkav gewölbt ist, und wobei die Fingerkuppen-Kontaktfläche (21) eine kreisringförmige oder eine kreisförmige Gestalt aufweist, und wobei die erste Fingerkuppen-Kontaktfläche (22) der Drehscheibe (12) bzw. des Drehrings (11), mit der die erste Welle (09) antreibbar ist, und die zweite Fingerkuppen-Kontaktfläche (21) der Drehscheibe bzw. des Drehrings (11), mit der die zweite Welle (10) antreibbar ist, auf der gleichen Höhe relativ zur Außenseite des Gehäuses der Lichtstellbedieneinheit (01) angeordnet sind.

2. Lichtstellbedieneinheit nach Anspruch 1,
**dadurch gekennzeichnet,**
**dass** an der ersten Welle (09) ein erstes Rastwerk zur Verrastung unterschiedlicher Drehlagen der ersten Welle (09) vorgesehen ist, wobei der erste Drehsignalgeber zur Erzeugung eines ein Umschalten zwischen zwei Rastlagen anzeigenden Datensignals vorgesehen ist, und wobei an der zweiten Welle (10) ein zweites Rastwerk zur Verrastung unterschiedlicher Drehlagen der zweiten Welle (10) vorgesehen ist, und wobei der zweite Drehsignalgeber zur Erzeugung eines ein Umschalten zwischen zwei Rastlagen anzeigenden Datensignals vorgesehen ist.

3. Lichtstellbedieneinheit nach einem der Ansprüche 1 bis 2,
**dadurch gekennzeichnet,**
**dass** die Rechnereinheit (20) einen Digitalspeicher zur Erzeugung, Verwaltung und Speicherung von Stellbefehlen umfasst.

4. Lichtstellbedieneinheit nach einem der Ansprüche 1 bis 3,
**dadurch gekennzeichnet,**
**dass** die Rechnereinheit (20) eine Anzeigeeinrichtung umfasst, wobei an der Anzeigeeinrichtung Grafikelemente für den Benutzer grafisch dargestellt werden können.

5. Lichtstellbedieneinheit nach Anspruch 4,
**dadurch gekennzeichnet,**
**dass** die Rechnereinheit (20) in der Art eines Laptops oder Personal Computers ausgebildet ist.

## Claims

1. A lighting control operating unit (01) for a lighting system, digital adjusting commands being generated in the lighting control operating unit (01), which commands can be transmitted to a processing unit (20) via a data link, and said lighting control operating unit (01) comprising several control elements, in particular key buttons (03), slide controls (04) and/or rotary controls (05), which are disposed at the upper side of a housing (02) and with the aid of which control commands can be entered,
**characterised in that**
at least one dual encoder (07) is provided in a control panel (08) of the lighting control operating unit (01), which dual encoder allows users to enter input values, wherein the dual encoder (07) presents a first shaft (09) being mounted in a housing (16) so as to be rotatable, and wherein a first rotation signal generator, for generating a data signal, is provided at the first shaft, and wherein a second shaft (10) being mounted in the housing (16) of the dual encoder (10) so as to be coaxially rotatable is provided at the dual encoder (07), and wherein a second rotation signal generator for generating a data signal is provided at the second shaft (10), and wherein both shafts (09, 10) present actuating elements (11, 12), at which adjusting movements can be transmitted onto the shafts (09, 10) by hand, and wherein the actuating elements, for hand-actuated adjustment of the shafts (09, 10), are embodied in the manner of a rotary disk (12) and/or of a rotary swivel (11) disposed in the control panel (08) of the lighting control operating unit (01) and configured to be coaxially turned in opposite directions, wherein the upper side(s) of the rotary disk (12) and/or of the rotary swivel (11) are/is embodied in the manner of a fingertip contact surface (21, 22), wherein the rotary disk (12) and/or the rotary swivel (11) can rotationally be driven by way of the engagement of a fingertip at the fingertip contact surface (21, 22), and wherein the fingertip contact surface (21, 22) is concave, and wherein the fingertip contact surface (21) presents an annular or a circular shape, and wherein the first fingertip contact surface (22) of the rotary disk (12) and/or of the rotary swivel (11), with the aid of which the first shaft (09) can be driven, and the second fingertip contact surface (21) of the rotary disk and/or of the rotary swivel (11), with the aid of which the second shaft (10) can be driven, are disposed on the same level in relation to the outside of the housing of the lighting control operating unit (01).

2. The lighting control operating unit according to claim 1,
**characterised in that**
a first locking mechanism, for locking different rotational positions of the first shaft (09), is provided at the first shaft (09), wherein the first rotation signal generator is provided for generating a data signal showing a switchover between two locking positions, and wherein a second locking mechanism for locking different rotational positions of the second shaft (10) is provided at the second shaft (10), and wherein the second rotation signal generator is provided for generating a data signal showing a switchover between two locking positions.

3. The lighting control operating unit according to any one of the claims 1 to 2,
**characterised in that**
the processing unit (20) comprises a digital memory for generating, managing and storing adjusting commands.

4. The lighting control operating unit according to any one of the claims 1 to 3,
**characterised in that**
the processing unit (20) comprises a display device, wherein graphic elements can graphically be depicted for users at the display device.

5. The lighting control operating unit according to claim 4,
**characterised in that**
the processing unit (20) is embodied in the manner of a laptop or of a personal computer.

## Revendications

1. Unité de commande d'éclairage (01) pour un système d'éclairage, des instructions de réglage numériques qui peuvent être transmises à une unité d'ordinateur (20) par une liaison de données étant générées dans l'unité de commande d'éclairage (01), et ladite unité de commande d'éclairage (01) comprenant plusieurs éléments de commande, en particulier des boutons poussoir (03), des curseurs (04) et/ou des boutons rotatifs (05), qui sont disposés sur le côté supérieur d'un boîtier (02) et à l'aide desquels des instructions de commande peuvent être entrées,
**caractérisée en ce**
**qu'**au moins un encodeur à deux arbres (07) est prévu dans un panneau de commande (08) de l'unité de commande d'éclairage (01), les utilisateurs pouvant entrer des valeurs d'entrée audit encodeur à deux arbres, ledit encodeur à deux arbres (07) présentant un premier arbre (09) monté dans un boîtier (16) de façon rotative, un premier générateur de signaux de rotation, pour générer un signal de données, étant prévu au premier arbre, et un deuxième arbre (10) monté dans le boîtier (16) de l'encodeur à deux arbres (10) à rotation coaxiale étant prévu à l'encodeur à deux arbres (07), et un deuxième générateur de signaux de rotation pour générer un signal de données étant prévu au deuxième arbre (10), et les deux arbres (09, 10) présentant des éléments d'actionnement (11, 12) auxquels des mouvements de réglage peuvent être transmis aux arbres (09, 10) à la main, et lesdits éléments d'actionnement, pour le réglage manuel des arbres (09, 10), étant réalisés à la manière d'un disque rotatif (12) et/ou d'une bague rotative (11) qui sont disposés dans le panneau de commande (08) de l'unité de commande d'éclairage (01) et qui peuvent être tordus coaxialement l'un contre l'autre, le(s) côté(s) supérieur(s) du disque rotatif (12) et/ou de la bague rotative (11) étant réalisé(s) à la manière d'une surface de contact de bout du doigt (21, 22), ledit disque rotatif (12) et/ou ladite bague rotative (11) pouvant être entraîné(s) de façon rotative moyennant l'engagement d'un bout du doigt à la surface de contact de bout du doigt (21, 22), et ladite surface de contact de bout du doigt (21, 22) étant voûtée de façon concave, et ladite surface de contact de bout du doigt (21) présentant une forme annulaire ou une forme circulaire, et ladite première surface de contact de bout du doigt (22) du disque rotatif (12) et/ou de la bague rotative (11), à l'aide de laquelle le premier arbre (09) peut être entraîné, et ladite deuxième surface de contact de bout du doigt (21) du disque rotatif et/ou de la bague rotative (11), à l'aide de laquelle le deuxième arbre (10) peut être entraîné, étant disposées au même niveau par rapport au côté extérieur du boîtier de l'unité de commande d'éclairage (01).

2. Unité de commande d'éclairage selon la revendication 1,
**caractérisée en ce**
**qu'**un premier mécanisme de verrouillage, assurant le verrouillage de positions de rotation différentes du premier arbre (09), est prévu au premier arbre (09), le premier générateur de signaux de rotation étant prévu pour générer un signal de données indiquant une commutation entre deux positions de verrouillage, et un deuxième mécanisme de verrouillage, assurant le verrouillage de positions de rotation différentes du deuxième arbre (10), étant prévu au deuxième arbre (10), et le deuxième générateur de signaux de rotation étant prévu pour générer un signal de données indiquant une commutation entre deux positions de verrouillage.

3. Unité de commande d'éclairage selon l'une quelconque des revendications 1 à 2,
**caractérisée en ce que**
l'unité d'ordinateur (20) comprend une mémoire numérique pour générer, gérer et stocker des instructions de réglage.

4. Unité de commande d'éclairage selon l'une quelconque des revendications 1 à 3,
**caractérisée en ce que**
l'unité d'ordinateur (20) comprend un dispositif d'affichage, des éléments graphiques pouvant être visualisés graphiquement pour l'utilisateur audit dispositif d'affichage.

5. Unité de commande d'éclairage selon la revendication 4,
**caractérisée en ce que**
l'unité d'ordinateur (20) est réalisée à la manière d'un ordinateur portable ou d'un ordinateur individuel.
